# EUROPEAN PATENT APPLICATION

(11) **EP 4 641 625 A1**
(43) Date of publication of application: **29.10.2025**
(21) Application number: 25160808.9
(22) Date of filing: 28.02.2025
(51) Int. Cl.: H01L 21/56, H01L 23/495

(54) **LEAD FRAME**

(30) Priority: 26.04.2024 CN 202420886640 U
(71) Applicant: Panjit Electronics (Wuxi) Co., Ltd., Jiangsu 214028 (CN)
(72) Inventor: FANG, Jeff, Jiangsu, 214028 (CN); HSIA, Cheng-Yu, Jiangsu, 214028 (CN); BAI, Guangyu, Jiangsu, 214028 (CN)
(74) Representative: Müller Schupfner & Partner Patent- und Rechtsanwaltspartnerschaft mbB (Muc)

(57) **Abstract**

A lead frame (10) including a plurality of chip package structures (2) and a plurality of horizontal long connecting bars (201, 207). The plurality of chip package structures each include a chip solderable area (206), a plurality of metal contacts (203, 204, 205) and at least one short connecting bar (202a, 202b). The plurality of metal contacts is electrically connected to the chip solderable area. The at least one short connecting bar is electrically connected to the plurality of metal contacts. The at least one short connecting bar electrically connects the plurality of metal contacts of one of the plurality of chip package structures to at least one of the plurality of horizontal long connecting bars adjacent thereto.

## Description

### Technical Field

The disclosure relates to a semiconductor package component, more particularly to a lead frame.

### Background

In general, after an entire lead frame is manufactured, a plurality of lead frames units is manufactured by cutting the lead frame. Conventionally, during the cutting process performed on the lead frame, one or more lateral metal contacts become separate islands that will be unable to be covered with soldering material in a subsequent rack plating process.

In this way, only a perspective mean, such as X-ray, can be used to inspect the quality of the soldering process, thereby increasing the cost of the inspection. In addition, due to the poor quality of the soldering process, the lead frame units may have poor soldering reliability, poor electrical conductivity and poor thermal conductivity.

### SUMMARY

The disclosure provides a lead frame including a short connecting bar electrically connected to metal contacts to realize Side Wettable Flank (SWF), thereby reducing the cost of the inspection and improving the quality of soldering process.

One embodiment of this disclosure provides a lead frame including a plurality of chip package structures and a plurality of horizontal long connecting bars. The plurality of chip package structures each include a chip solderable area, a plurality of metal contacts and at least one short connecting bar. The plurality of metal contacts is electrically connected to the chip solderable area. The at least one short connecting bar is electrically connected to the plurality of metal contacts. The at least one short connecting bar electrically connects the plurality of metal contacts of one of the plurality of chip package structures to at least one of the plurality of horizontal long connecting bars adjacent thereto.

According to the lead frame disclosed by above embodiments, the short connecting bar electrically connects the metal contacts of one of the chip package structures to the at least one horizontal long connecting bar adjacent thereto. Thus, after the cutting process, the electrical conduction between the metal contacts and other components are maintained to ensure the solderable metal layer and the solder material to be applied to the metal contacts in the electroplating process. In this way, the Side Wettable Flank package can be realized, and the quality of the soldering process can be inspected by directly observing the metal contacts exposed to the outside without using a perspective mean, such as X-ray. Thus, the cost of the inspection is reduced. In addition, the quality of the soldering process is improved, thereby enhancing the soldering reliability, the electrical conductivity and the thermal conductivity of the lead frame units formed by the lead frame.

### BRIEF DESCRIPTION OF THE DRAWINGS

The present disclosure will become better understood from the detailed description given herein below and the accompanying drawings which are given by way of illustration only and thus are not intended to limit the present disclosure and wherein:
FIG. 1 is a top view of a lead frame according to one embodiment of the disclosure;
FIG. 2 is a partially enlarged view of the lead frame in FIG. 1;
FIG. 3 is a top schematic view showing the flow of current on the lead frame in FIG. 1; and
FIG 4 is a cross-sectional view of the lead frame taken along line 4-4 in FIG. 3.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

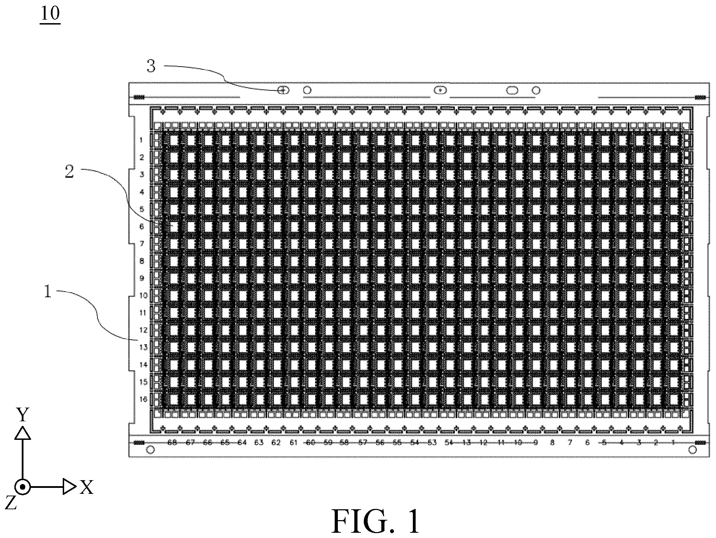

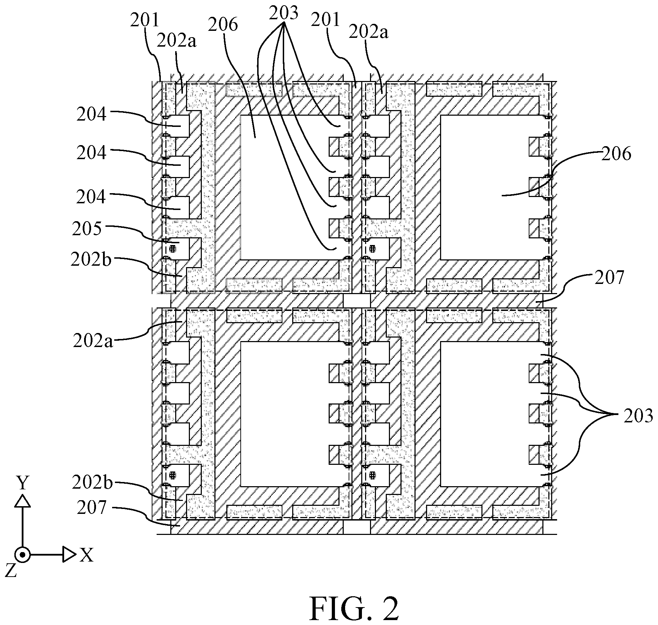

Referring to FIGS. 1 and 2. FIG. 1 is a top view of a lead frame 10 according to one embodiment of the disclosure. FIG. 2 is a partially enlarged view of the lead frame 10 in FIG. 1. In this embodiment, the lead frame 10 includes an outer frame 1, a plurality of chip package structures 2 and a plurality of horizontal long connecting bars 207. The outer frame 1 surrounds and is electrically connected to the plurality of chip package structures 2. The outer frame 1 is made of, for example, metal. In addition, the outer frame 1 includes, for example, a plurality of locating holes 3. The locating holes 3 are located on a top edge and a bottom edge of the outer frame 1. During a process of packaging the soldered chip by epoxy, the locating holes 3 allow the outer frame 1 to be positioned or held in position, thereby ensuring the reliability and stability of the lead frame 10. Furthermore, a rear surface of the outer frame 1 may be covered with a film, so as to prevent the glue to overflow by ensuring the molding material and the package unit to be flush with each other during the molding process.

The chip package structures 2 are, for example, arranged in an array. Also, the chip package structures 2 have similar structures, and thus the detailed structure of one of the chip package structures 2 will be described hereinafter.

In this embodiment, the chip package structure 2 includes a chip solderable area 206, a plurality of right metal contacts 203, a plurality of left-top metal contacts 204, a left-bottom metal contact 205, a top short connecting bar 202a, a bottom short connecting bar 202b and a horizontal long connecting bar 201.

The chip solderable area 206 is configured to allowed a chip to be mounted and positioned thereon. The right metal contacts 203 are electrically connected to the chip solderable area 206. The left-top metal contacts 204 are electrically connected to one another, and are spaced apart from the chip solderable area 206. The top short connecting bar 202a is electrically connected to the left-top metal contacts 204 and exposed to the outside. The bottom short connecting bar 202b is electrically connected to the left-bottom metal contact 205. The horizontal long connecting bar 201 is electrically connected to the left-top metal contacts 204.

In this embodiment, an extension direction (i.e., Y-axis direction) of the top short connecting bar 202a, the bottom short connecting bar 202b and the horizontal long connecting bar 201 is, for example, perpendicular to an extension direction (i.e., X-axis direction) of the horizontal long connecting bars 207.

The horizontal long connecting bars 207 are electrically connected to the chip solderable areas 206 of the chip package structures 2, respectively. Moreover, one horizontal long connecting bar 207 electrically connects the top short connecting bar 202a of one chip package structure 2 and the bottom short connecting bar 202b of another adjacent chip package structure 2.

That is, the top short connecting bar 202a electrically connects the left-top metal contacts 204 to the top horizontal long connecting bar 207; the bottom short connecting bar 202b electrically connects the left-bottom metal contact 205 to the bottom horizontal long connecting bar 207.

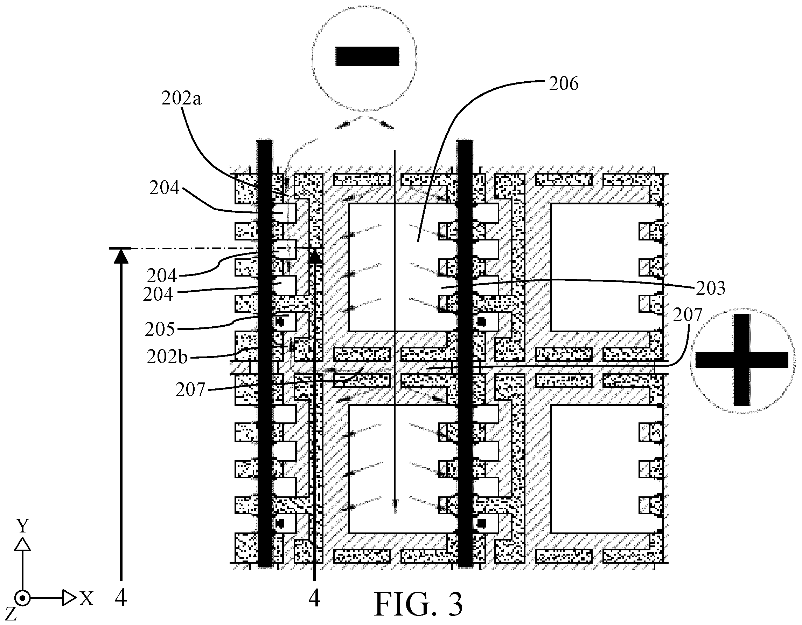

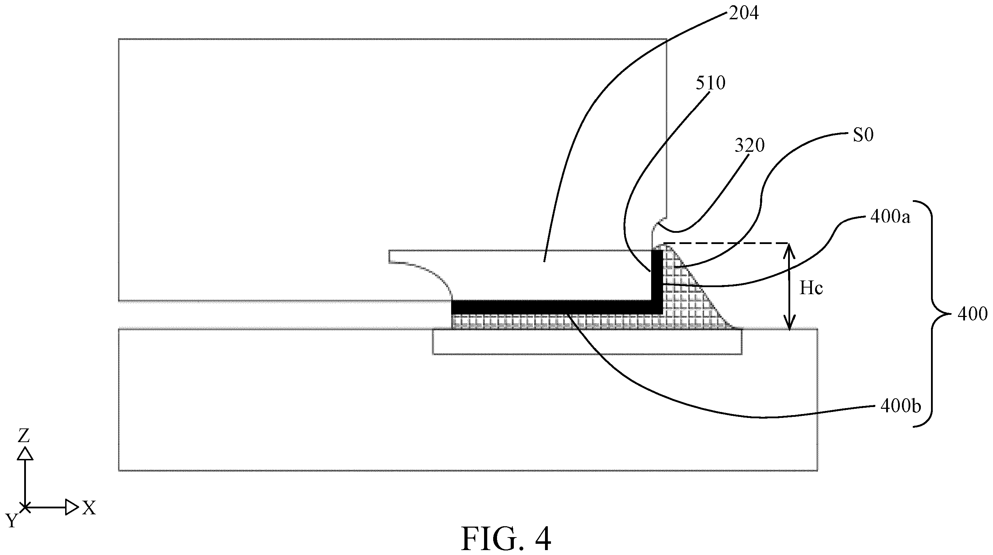

Next, referring to FIGS. 3 and 4. FIG. 3 is a top schematic view showing the flow of current on the lead frame 10 in FIG. 1. FIG 4 is a cross-sectional view of the lead frame 10 taken along line 4-4 in FIG. 3. After the horizontal long connecting bar 201 is entirely cut, the left-top metal contacts 204 spaced apart from one another are electrically connected to the top short connecting bar 202a, so as to allow the current flowing from the top horizontal long connecting bar 207 to form a series circuit, thereby realizing lateral and vertical electrical conduction by the left-top metal contacts 204. Also, the current flowing from the bottom horizontal long connecting bar 207 flows to the left-bottom metal contact 205 through the bottom short connecting bar 202b, thereby realizing lateral and vertical electrical conduction. In addition, the right metal contacts 203 electrically connected to the chip solderable area 206 are also allowed to receive the current flowing from the horizontal long connecting bar 207, thereby completing the electroplating. It is ensured that the left metal contacts (including left-top metal contacts 204 and the left-bottom metal contact 205) are electrically connected to the top and bottom horizontal long connecting bars 207 respectively via the top short connecting bar 202a and the bottom short connecting bar 202b even after the horizontal long connecting bar 201 is entirely cut. Thus, the electrical conduction between the left metal contacts and other components are maintained so that the electroplating is allowed to be performed by a current barrel, thereby ensuring a solderable metal layer 400 to be applied to all of the left metal contacts and the right metal contacts 203 whose electrical conduction is maintained. For example, the solderable metal layer 400 is made of metal, such as silver, nickel or gold. The solderable metal layer 400 includes, for example, a lateral solderable metal layer 400a and a bottom solderable metal layer 400b. In addition, for example, the positive label in FIG. 3 corresponds to an anode of an electroplating apparatus and the negative label in FIG. 3 corresponds to a cathode of the electroplating apparatus.

Further, as shown in FIG. 4, a solder material S0 (e.g., made of tin) covers the lateral solderable metal layer 400a and the bottom solderable metal layer 400b, and the solder material S0 wets along the lateral solderable metal layer 400a on a lateral surface 510 to cover the left-top metal contact 204 by an entire thickness thereof. Since a cutout 320 is recessed inwards from a peripheral wall of a molding material, a creepage height Hc with respect to the lateral solderable metal layer 400a may be facilitated to be higher than the thickness of the left-top metal contact 204. Thus, the lateral surface of the left-top metal contact 204 is entirely covered with tin, thereby enhancing the mechanical stress resistance thereof.

According to the lead frame disclosed by above embodiments, the short connecting bar electrically connects the metal contacts of one of the chip package structures to the at least one horizontal long connecting bar adjacent thereto. Thus, after the cutting process, the electrical conduction between the metal contacts and other components are maintained to ensure the solderable metal layer and the solder material to be applied to the metal contacts in the electroplating process. In this way, the Side Wettable Flank package can be realized, and the quality of the soldering process can be inspected by directly observing the metal contacts exposed to the outside without using a perspective mean, such as X-ray. Thus, the cost of the inspection is reduced. In addition, the quality of the soldering process is improved, thereby enhancing the soldering reliability, the electrical conductivity and the thermal conductivity of the lead frame units formed by the lead frame.

It will be apparent to those skilled in the art that various modifications and variations can be made to the present disclosure. It is intended that the specification and examples be considered as exemplary embodiments only, with a scope of the disclosure being indicated by the following claims and their equivalents.

## Claims

1. A lead frame (10), comprising:
a plurality of chip package structures (2), each comprising:
a chip solderable area (206);
a plurality of metal contacts (203, 204, 205), electrically connected to the chip solderable area; and
at least one short connecting bar (202a, 202b), electrically connected to the plurality of metal contacts; and
a plurality of horizontal long connecting bars (201, 207), wherein the at least one short connecting bar electrically connects the plurality of metal contacts of one of the plurality of chip package structures to at least one of the plurality of horizontal long connecting bars adjacent thereto.

2. The lead frame according to claim 1, wherein the plurality of metal contacts of each of the plurality of chip package structures include a plurality of left-top metal contacts (204).

3. The lead frame according to claim 2, wherein each of the plurality of chip package structures further comprises a horizontal long connecting bar (201, 207) electrically connected to the plurality of left-top metal contacts.

4. The lead frame according to claim 2, wherein the plurality of metal contacts of each of the plurality of chip package structures further include a left-bottom metal contact (205), in each of the plurality of chip package structures, the at least one short connecting bar comprises a top short connecting bar (202a) and a bottom short connecting bar (202b), the top short connecting bar is electrically connected to the plurality of left-top metal contacts, and the bottom short connecting bar is electrically connected to the left-bottom metal contact.

5. The lead frame according to claim 4, wherein each of the plurality of horizontal long connecting bars further electrically connect the top short connecting bar of one of the plurality of chip package structures and the bottom short connecting bar of another one of the plurality of chip package structures adjacent thereto.

6. The lead frame according to claim 2, wherein each of the plurality of chip package structures further comprises a plurality of right metal contacts (203) electrically connected to the chip solderable area.

7. The lead frame according to claim 1, wherein an extension direction of the at least one short connecting bar of each of the plurality of chip package structures is perpendicular to an extension direction of the plurality of horizontal long connecting bars.

8. The lead frame according to claim 1, wherein the plurality of chip package structures is arranged in an array.

9. The lead frame according to claim 1, further comprising an outer frame (1) surrounding and being electrically connected to the plurality of chip package structures.

10. The lead frame according to claim 9, wherein the outer frame comprises at least one locating hole (3).
